# EUROPEAN PATENT SPECIFICATION

(11) **EP 4 653 883 B1**
(45) Date of publication and mention of the grant of the patent: **07.10.2026**
(21) Application number: 24177350.6
(22) Date of filing: 22.05.2024
(51) Int. Cl.: G01R 31/12, G01R 31/34

(54) **METHOD FOR TESTING AN INSULATION RESISTANCE OF AN INSULATED MAGNETIC WIRE**
VERFAHREN ZUM TESTEN EINES ISOLATIONSWIDERSTANDES EINES ISOLIERTEN MAGNETISCHEN DRAHTES
PROCÉDÉ DE TEST D'UNE RÉSISTANCE D'ISOLATION D'UN FIL MAGNÉTIQUE ISOLÉ

(43) Date of publication of application: 26.11.2025
(73) Proprietor: Volvo Car Corporation, 405 31 Göteborg (SE)
(72) Inventor: KAMAL, Arian, 40531 Göteborg (SE); KALLIO, Kai, 40531 Göteborg (SE)
(74) Representative: Kransell & Wennborg KB

(56) References cited:
- DE-A1- 102020 007 752
- JP-B2- 5 617 179
- US-A1- 2016 282 403
- BEYER M ET AL: "Investigation of damage-behavior in cast epoxy resin coils under thermal and electrical stress with the help of partial discharge (PD) measurements", PROCEEDINGS OF THE INTERNATIONAL CONFERENCE ON PROPERTIES AND APPLICATIONS OF DIELECTRIC MATERIALS. TOKYO, JULY 8 - 12, 1991; [PROCEEDINGS OF THE INTERNATIONAL CONFERENCE ON PROPERTIES AND APPLICATIONS OF DIELECTRIC MATERIALS], NEW YORK, IEEE, US, vol. CONF. 3, 8 July 1991 (1991-07-08), pages 695 - 698, XP010036672, ISBN: 978-0-87942-568-5, DOI: 10.1109/ICPADM.1991.172160

## Description

### TECHNICAL FIELD

The present disclosure relates to a method for testing an insulation resistance of an insulated magnetic wire.

### BACKGROUND ART

Insulated magnetic wires are for example used to wind coils in stators and rotors of electric motors, providing necessary electromagnetic fields for motor operation. A proper insulation is required to prevent short circuits, electrical faults, and motor malfunctions. The insulation resistance of insulated magnetic wires in the context of automotive applications may be affected over time by factors such as high voltage, temperature variations, mechanical stress, and environmental conditions.

Test methods for electrical insulation of electric motor wires or magnetic wires are usually conducted at room temperature or elevated temperatures (well above 0 °C). Such a method and device is disclosed in JP 5 617 179 B2. However, in certain situations, e.g., when a vehicle with an electrical motor is parked in a cold environment, for instance at -30 °C, the test methods do not deliver realistic results such that the electrical insulation designed based on the results of such test methods may fail during these situations. For example, in a cold environment, a high acceleration at a start of driving the vehicle may cause generation of particularly high electrical voltage in the electric motor wires. This high voltage may cause stress in the electrical insulation provided on the electric motor wires and affect insulation properties. The electrical insulation properties influence the overall lifetime expectancy of the electric motor.

### SUMMARY

The problem is at least partially solved or alleviated by the subject matter of the independent claim of the present disclosure, wherein further examples are incorporated in the dependent claims.

There is provided a method for testing an insulation resistance of an insulated magnetic wire, for example for testing an insulated magnetic wire as generally used for an electrical motor of a vehicle. The insulated magnetic wire comprises a wire portion and an insulation portion enclosing the wire portion. The method comprises cooling the insulated magnetic wire to a temperature below 0 °C. The method further comprises applying an electric potential difference between the wire portion and an electrically conductive material at least partially surrounding the insulation portion and increasing the electric potential difference until at least one of a partial discharge and a voltage breakdown of the insulated magnetic wire occurs.

Besides the wire portion, the insulated magnetic wire comprises an insulation portion, which may comprise one or more insulation materials. For example, a substantially electrically non-conductive or electrically non-conductive material as insulation material such as, but not limited to, a thermoplastic on the magnetic wire may electrically, and optionally thermally, insulate the wire portion of the magnetic wire of the electrical motor. As will be discussed more in detail below, according to examples the insulation portion encloses the wire portion (except for that two ends of the wire portion are left uncovered, enabling the wire portion to be electrically connected, for instance to a voltage source). The method may test insulation resistance or, in other words, insulation integrity of the insulated magnetic wire, for instance the insulation integrity of the insulation portion of the insulated magnetic wire. Insulation resistance may be defined as an electrical resistance of the insulation material of the insulation portion, to a flow of an electrical current through the wire portion, or as a resistance to conducting current between two electrical conductors separated by the insulation material. The method may test the electric potential difference that causes the insulation material to stop resisting the electrical current flow through the wire portion of the insulated magnetic wire of the electrical motor. When the mentioned electric potential difference is exceeded, and for example in case the insulation portion has a structural defect, electrical current may be conducted through the insulation portion and the partial discharge or voltage breakdown of the insulated magnetic wire, or its insulation portion, may occur.

The method comprises cooling the insulated magnetic wire to a temperature below 0 °C, in particular to a temperature in a temperature range from -40 °C to 0 °C, more particularly from -30 °C to -5 °C. The method may comprise providing the insulated magnetic wire in an environment having a temperature below 0 °C. The method may comprise measuring the temperature of the insulated magnetic wire. The measured temperature below 0 °C may be representative of a vehicle parked outdoors in a cold region or cold season, e.g., during winter time. Accordingly, testing under temperatures below zero may provide a realistic and an accurate method for testing the insulation of the magnetic wire of the electrical motor.

In an example, the method may comprise immersing the insulated magnetic wire at least partially into an electrically conductive material. The insulated magnetic wire is immersed into the electrically conductive material such that the insulation portion is at least partially or completely surrounded by the electrically conductive material. The electric potential difference (in other words, electric voltage difference) may be provided to the insulated magnetic wire by applying a first potential to the wire portion and a different second potential to the electrically conductive material at least partially surrounding the insulation portion of the insulated magnetic wire. Accordingly, application of the electric potential difference may mean that the insulation portion may be subjected to a voltage difference between the two different potentials (the first potential and the second potential). The insulated magnetic wire may be immersed into the electrically conductive material before or after cooling the insulated magnetic wire to a temperature below 0 °C.

The method comprises increasing the electric potential difference or, in other words, voltage, between the wire portion and the electrically conductive material at least partially surrounding the insulation portion. In other words, increasing the difference in applied electric potential, hence, what herein referred to as electric potential difference, between the wire portion of the insulated magnetic wire and its surrounding structure or material, e.g., the electrically conductive material, from which the wire portion is separated by the insulation portion, until at least one of a partial discharge and a voltage breakdown of the insulated magnetic wire occurs. Partial discharge generally means that a flow of electric current may be created within the insulation portion of the wire portion during a period of time, for instance during a number of milliseconds or seconds, but that the breakdown of the insulation portion is not complete and permanent. After partial discharge, the insulation portion can go back to acting as electrical insulation for the wire portion again. Complete breakdown, also referred to as voltage breakdown, on the other hand, generally means that the insulation portion irreversibly breaks down, hence is completely and permanently destroyed, and can no longer acts as insulation for the wire portion The voltage and/or time before (or at a moment of) the partial discharge or voltage breakdown may be indicative of a breakdown of the insulation resistance of the insulation material. As explained in detail below, partial discharge or voltage breakdown of the insulated magnetic wire (specifically the insulation portion) may cause a sudden voltage increase (a peak in voltage measurement) which may be detected by a control unit. The time of the partial discharge or voltage breakdown may be also recorded by the control unit. With the breakdown of the insulation resistance as a result of partial discharge or voltage breakdown, the applied electric potential difference may cause a flow of electric current through the insulation portion, in particular between the wire portion and its surrounding portion, e.g., electrically conductive material. Partial discharge may mean a localized electrical discharge that occurs within the insulation portion of the insulated magnetic wire, e.g., due to a defect, an imperfection, a void, or a contaminant. Similar to partial discharge, voltage breakdown may occur if an electrical breakdown or insulation failure occurs. Accordingly, after voltage breakdown, the insulation portion may not be insulating the wire portion anymore, e.g., due to an increased defect, imperfection, void or similar as effect of the increased electric potential difference. In any case, the voltage breakdown or partial discharge may cause a sudden electric current flow from the magnetic wire and thereby allowing detection of the partial discharge or voltage breakdown of the (insulation portion of the) insulated magnetic wire. The electric current flow due to partial discharge may be lower than the electric current flow due to voltage breakdown. If voltage is increased further than the voltage breakdown, the voltage (or the applied electric potential difference) at the wire portion of the magnetic wire may drop to 0 Volts.

Applying the electric potential difference may mean that the first electric potential is applied to the wire portion and the second electric potential, different from the first electric potential, is applied to the electrically conductive material, as herein explained. The difference between the first electric potential and the second electric potential applied to the wire portion and the insulation portion may create a potential difference at the insulation portion. The first electric potential applied to the wire portion may be, for instance, above 0 Volts and the second electric potential applied to the electrically conductive material may be, for instance, 0 Volts (ground). In another example, the first electric potential applied to the wire portion may be, for instance, 0 Volts and the second electric potential applied to the electrically conductive material may be, for instance, above 0 Volts. In both cases, the electric potential difference applied to the insulation portion may be more than 0 Volts and thereby may create the electric current flow if partial discharge or voltage breakdown occurs. For increasing the electrical potential difference, both or only one of the electric potentials may be increased.

According to an example, the (increased) electric potential difference before (or during) the at least one of the partial discharge and the voltage breakdown may be recorded. The recording may comprise the time of occurrence of the partial discharge or voltage breakdown and the electric potential difference or, in other words, voltage, for example by the control unit. The recorded voltage may provide information about an electrical insulation capacity of the insulation material to withstand the voltage at the temperature below 0 °C.

According to an example, the insulated magnetic wire may be an insulated hairpin for the electrical motor. A hairpin may be a configuration of a winding of the magnetic wire of the electric motor. In other words, the insulated magnetic wire may be formed into a hairpin shape comprising at least two legs extending substantially in parallel from a connection portion.

According to an example, the insulated magnetic wire may comprise an at least partially bent form, in particular a substantially U- or V-shape. The bent form may be exposed to a higher increase in stress and may demonstrate weaker insulation resistance. The bent form may comprise an extended portion and a compressed portion on opposite sides of the insulated magnetic wire. The bent form of the insulated magnetic wire may demonstrate characteristics of the extended portion and the compressed portion during partial discharge and voltage breakdown at once. Accordingly, the method for testing the insulated magnetic wire comprising the at least partially bent form may provide an accurate and efficient method for testing a weaker insulation resistance simulated based on the bent form of the magnetic wire, such as may be the case in the application using the magnetic wire or for simulating an aged magnetic wire, for example.

Alternatively or additionally, the insulated magnetic wire may be an elongated (e.g., extended or stretched) magnetic wire, preferably having a straight form, in particular without bends or curves, or a bent form. For example, the elongated insulated magnetic wire may be stretched by 30% more of its original length. Elongated or stretched may mean that the insulation portion and/or the wire portion of the insulated magnetic wire is extended at a predefined percentage. Thus, the length of the magnetic wire may be elongated compared to an original length of the magnetic wire before extension. An electric field distribution within the straight wire may be more uniform along its length compared to the U- or V-shaped magnetic wire. Absence of stress concentrations due to bends or curves may result in a more predictable and uniform breakdown or partial discharge behavior and thus more accurate test results. Further, an elongated magnetic wire may comprise impurities caused during extension. Thus, elongated insulated magnetic wire may undergo partial discharge or voltage breakdown in shorter time or at a lower electric potential difference than a magnetic wire at the original length, thereby simulating an aged magnetic wire.

According to an example, the electric potential difference may be increased in pre-defined increments of voltage per time. For example, the electric potential difference or, in other words, voltage may be increased at a rate of 0,1-5 kV (kilo Volts) every few seconds, e.g., in the range of 10 to 30 seconds. The electric potential difference may be increased in compliance with UL (Underwriters Laboratories) or ASTM (American Society for Testing and Materials) standards, for instance at a rate of 0,5 kV/sec (500V/sec) per second, or as an example, the electric potential difference may be increased 1 kV every 30 seconds. Alternatively, the electric potential difference may be increased in a decreasing manner. For instance, the electric potential difference may be initially increased 1kV every 30 seconds for 2 minutes, afterwards 0,5 kV every 30 seconds for 2 minutes and 0,01 kV until the voltage breakdown or partial discharge occurs. Thereby, an even more accurate measurement may be performed.

According to an example, the electrically conductive material may be a cover that is wrapped around the insulation portion, for instance, an aluminum cover. The method may comprise wrapping the cover (in this case, preferably made of the electrically conductive material) at least partially around the insulation portion of the insulated magnetic wire before applying the electric potential difference between the wire portion and the electrically conductive material. Surrounding the insulation portion by the electrically conductive material of the cover may provide an increased contact of the insulation portion to the electrically conductive material. Thereby, when partial discharge or voltage breakdown occurs, the created electric current may flow from anywhere on the insulated magnetic wire corresponding to the partial discharge or voltage breakdown of the insulation portion.

According to an example, the insulated magnetic wire may be at least partially immersed in a container filled with a filler structure comprising the electrically conductive material. Alternative to what is explained below, the electric potential difference may be applied between the wire portion and the container. In this case, the container may be of the electrically conductive material. The container may still contain the electrically conductive material at least partially surrounding the insulation portion. A surface of the container may be electrically insulated via an insulation sheet or similar for safe handling of the container when needed. The wire portion of the insulated magnetic wire that is immersed into the container, or in the filler structure inside the container, must be completely enclosed by the insulating portion in order not to cause short-circuit. Accordingly, the method may comprise providing the insulated magnetic wire in contact with the filler structure inside the container. For example, the container may be configured to have a size and shape for containing the insulated magnetic wire and the filler structure. For example, the container may have a cylindrical or a rectangular prism form. The container filled with the filler structure may provide support for placing the magnetic wire therein. The container may have an open top side, allowing placement of the insulated magnetic wire with the filler structure therein. The container may also comprise a lid for closing the open top of the container. In this case, the lid may comprise at least one opening for at least one of a connection to a power supply unit and a temperature sensor. The temperature sensor may be provided in the container in contact with the filler structure. The temperature sensor may comprise a display unit for displaying the temperature of the filler structure. The temperature sensor may be connected to the display unit through a connection means. The connection means may be wireless or a cable. According to an example, the method for testing an insulation resistance of an insulated magnetic wire, according to the present disclosure, may be performed by means of a test set-up prepared according to IEC 60851-5, "U-bend specimen for the breakdown voltage test", according to NEMA MW 1000-2020) for breakdown voltage (BDV).

According to an example, the filler structure may comprise a plurality of filler elements comprising the thermally and/or electrically conductive material. The filler elements may be of metal (e.g., steel). The filler elements may be configured to at least partially, in particular substantially completely, surround the insulated magnetic wire. The filler elements may provide a large contact surface of the insulated magnetic wire for an efficient heat transfer of the insulated magnetic wire. Accordingly, a homogenous temperature distribution may be achieved on the magnetic wire. With this set-up, the insulated magnetic wire may be cooled below 0 ° C in a uniform and efficient manner. Further, the filler structure, by providing a large contact surface with the magnetic wire, may cover a wide area on a surface of the insulated magnetic wire corresponding to a higher number of possible structural breakdowns in the insulation portion. Many contact points between the filler structure and the insulating magnetic wire may increase the probability of detecting areas where partial discharge or voltage breakdown of the insulated magnetic wire can occur. The filler elements may have a spherical shape. The filler elements may have an extension in diameter, thus maximum extension in diameter, of 5 mm or less, particularly 2 mm or less. The filler elements may for example be in a form of a (fine-)granular filling such as for example a metal powder. The granular filling may comprise filler elements of diameters ranging from a few micrometers to 100 micrometers (0,1 millimeter), for instance, 10 micrometers to 100. The metal powder may conduct heat to an even extended contact surface by having more contact points to the insulated magnetic wire compared to the filler elements with larger diameter than the (fine-)granular filling. Thus the (fine-)granular filling provides a faster decrease in the temperature of the insulated magnetic wire. Accordingly, a time for cooling the insulated magnetic wire, to a temperature below 0 °C, may be controlled by choosing the form and size of the filler elements of the filler structure.

According to an example, the electric potential difference may be applied by the power supply unit having a first (e.g., positive) terminal electrically connected (or connectable) to the wire portion of the insulated magnetic wire and having a second (e.g., negative) terminal electrically connected (connectable) to the electrically conductive material. The power supply unit may supply voltage within a range of 35 to 80 kV, for example. The second terminal may be either directly or indirectly connected to the electrically conductive material, e.g., via the container, wherein the container may comprise a conductive material. If the container does not comprise or is not made of a conductive material, the second terminal may be, preferably electrically connected to the electrically conductive material directly.

A first cable may be connected between the first terminal of the power supply unit and the wire portion of the magnetic wire. The first electric potential may be applied to the wire portion by the power supply unit through the first cable. A second cable may be connected between the second terminal of the power supply unit and the electrically conductive material. A ground voltage may be applied to the electrically conductive material, or the wire portion, for example. Thereby, an electrical potential of zero or ground may be established e.g. at the electrically conductive material. Therewith, an electric voltage difference may be applied to the wire portion of the insulated magnetic wire provided in the container. The voltage difference may cause the electric current to flow through the magnetic wire through the insulation portion, e.g., based on a defect of the insulation portion, causing the partial discharge or voltage breakdown inside the insulation portion. The method may comprise connecting the first terminal of the power supply unit to the wire portion after inserting the magnetic wire into the container and cooling the filler structure thereafter.

According to an example, the method may further comprise keeping the electrically conductive material at a pre-defined temperature range below 0 °C for a pre-defined duration before applying the electric potential difference to the wire portion of the insulated magnetic wire. The temperature of the electrically conductive material may be measured during the pre-defined duration. The electrically conductive material may be kept at the pre-defined temperature range below 0 °C for at least 10 minutes, preferably for at least 10 to 30 minutes, or even more preferably for an even longer period of time. If the temperature of the electrically conductive material raises above 0 °C, the method may further comprise repeating cooling of the insulated magnetic wire below 0 °C. By keeping the temperature of the electrically conductive material constant at the pre-defined temperature, the method may prevent sudden stress increase in the magnetic wire. Accordingly, the insulated magnetic wire may be tested safely and/or more accurately.

According to an example, the insulated magnetic wire may be a pre-aged insulated magnetic wire, or the insulated magnetic wire may be stretched. Pre-aged may mean that the insulated magnetic wire has, for a certain period of time, undergone a certain treatment or experienced specific conditions, e.g., temperature conditions and/or current supply, that might cause degradation or, in other words, aging of the insulated magnetic wire, in particular of the insulation portion of the magnetic wire. Similar effects on the insulation portion may be achieved with a stretched magnetic wire. By testing a pre-aged or stretched magnetic wire, electrical properties such as the breakdown voltage and partial discharge voltage can be evaluated for long-term reliability and performance of the magnetic wire when being used in a vehicle for a long time. For example, the pre-aged insulated magnetic wire may have been pre-aged at a temperature of 100 °C or more, for example at 100-180 °C, for 100 hours or more, e.g., for 500 hours or 1000 hours or more, with or without supply of electric current to the wire portion at this time. For instance, the insulated magnetic wire may have been heated to 155 °C and kept at this temperature for 1000 hours. Such pre-aged magnetic wire may reflect a more realistic behavior of an insulated magnetic wire that has been in use for a while. Also, the testing at low temperatures below 0 °C does not need to be performed for 100 or more hours, but can be done for a short period of time only to realistically test the insulation resistance at low temperatures for a used insulated magnetic wire.

According to an example, the wire portion of the insulated magnetic wire may comprise at least one of copper and aluminum. However, the wire portion may alternatively or additionally comprise any other material that is electrically and/or thermally conductive.

According to an example, the insulation portion of the insulated magnetic wire may comprise one layer of the insulation material or multiple layers of the insulation material. The method may comprise applying a starting voltage (test voltage) at a higher level for the insulated magnetic wire comprising the multiple layers of insulation material compared to the insulated magnetic wire comprising the single layer of insulation material. The insulation material may comprise a polymer, specifically a thermoplastic polymer for example Polyethylene (PE), Polypropylene (PP), Polyvinyl chloride (PVC), or Polyether ether keton (PEEK).

According to an example, an arrangement for testing an insulation resistance of an insulated magnetic wire for an electrical motor of a vehicle may be provided. The arrangement may comprise the mentioned container filled with the filler structure comprising the thermally and/or electrically conductive material. The arrangement may further comprise the power supply unit. The power supply unit may comprise the first and the second terminals and the first and the second cables. The electric potential difference may be applied at the wire portion by connecting the first cable to the wire portion and the second cable to the electrically conductive material. By providing a positive potential through the first (positive) terminal to the magnetic cable via the wire portion and for instance, ground potential through the second (negative) terminal to the electrically conductive material, the voltage difference may be provided at the wire portion of the magnetic wire. The power supply unit may increase the potential difference applied to the wire portion of the insulated magnetic wire provided in the container. The potential difference may be increased through the power supply unit until at least one of the partial discharge and the voltage breakdown of the insulation portion of the magnetic wire occurs. The voltage difference may cause the electric current to flow through the insulation portion, e.g., when a defect is present in the insulation portion, leading to the partial discharge or voltage breakdown to occur in the insulated magnetic wire. The arrangement may further comprise the temperature sensor in contact with the electrically conductive material. The temperature sensor may comprise the display unit for displaying the temperature of the electrically conductive material. The temperature sensor may be connected to the display unit through the connection means. The connection means may be wireless or a cable. The arrangement may be used to carry out the mentioned method for testing the insulation resistance of the insulated magnetic wire, for instance the insulation portion thereof.

Other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a schematic representation of an arrangement for carrying out a method for testing an insulation resistance of an insulated magnetic wire;
- Figure 2: shows a flow diagram of a method for testing an insulation resistance of an insulated magnetic wire.

### DETAILED DESCRIPTION

The Figures are merely schematic representations and serve only to illustrate examples of the disclosure. Identical or equivalent elements are in principle provided with the same reference signs.

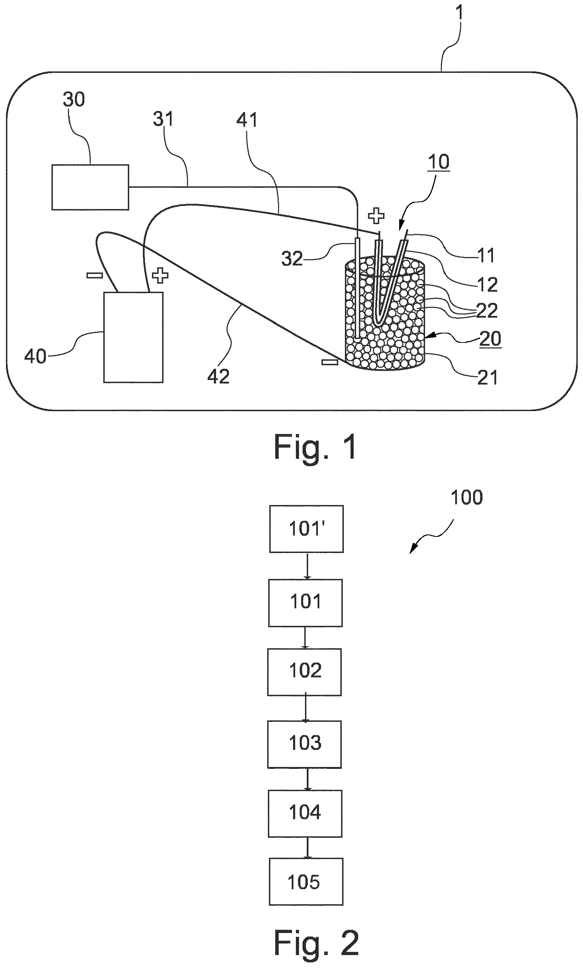

Figure 1 shows a schematic representation of an arrangement 1 for carrying out a method 100 for testing an insulation resistance of an insulated magnetic wire 10, for example suitable for use in an electrical motor of a vehicle (not shown). An insulated magnetic wire 10 may e.g. be an insulated wire having a wire portion 11, for instance an electrically conductive core of Aluminum (Al) or Copper (Cu). The insulated magnetic wire 10 shown in Figure 1 comprises a wire portion 11 and an insulation portion 12 enclosing the wire portion 11. The insulated magnetic wire 10 is immersed into a container 20. The insulation portion 12 of the insulated magnetic wire 10 is surrounded by the electrically conductive material in the container 20. The container 20 is exemplary embodied with a cylindrical shape, and filled with a filler structure 21 comprising the electrically conductive material. The filler structure 21 comprises a plurality of filler elements 22 comprising the electrically conductive material. The arrangement 1 comprises a power supply unit 40 comprising a first terminal and a second terminal. The first terminal is depicted exemplary as a positive terminal and the second terminal is depicted exemplary as a negative terminal.

A first cable 41 is connected to the first terminal and the wire portion 11 of the magnetic wire 10. A second cable 42 is connected to the second terminal and to the container 20. In this example, the container 20 comprises or is made from an electrically conductive material such that it may conduct electrical current to the filter structure 21. However, alternatively, the container 20 may comprise or be made from an electrically insulating material, e.g., glass and the second cable 42 may be directly connected to the filler structure 21 instead.

An electric potential difference is applied between the wire portion 11 of the insulated magnetic wire 10 and the electrically conductive material inside the container 20 or filler structure 21. The potential difference is increased through the power supply unit 40 until at least one of the partial discharge and the voltage breakdown of the insulation portion 12 of the magnetic wire 10 occurs. The voltage difference, in particular when there is a defect inside the insulation portion 12, causes an electric current to flow through the insulation portion 12. Thereby, partial discharge or voltage breakdown occurs.

The arrangement 1 also comprises a temperature sensor 32 in contact with the filler structure 21. The temperature sensor 32 of this example comprises a display unit 30 for displaying the temperature of the filler structure 21. The temperature sensor 32 is connected to the display unit 30 through a connection means 31, which is exemplary depicted as a cable.

Figure 2 shows a flow diagram of a method 100 for testing the insulation resistance of the insulated magnetic wire 10. The method 100 comprises initially cooling the insulated magnetic wire 10 to a temperature below 0 °C (step 101). Afterwards, immersing the insulated magnetic wire 10 at least partially into an electrically conductive material, wherein the insulation portion 12 is surrounded by the electrically conductive material (step 104). An electric potential difference is applied between the wire portion 11 and the electrically conductive material surrounding the insulation portion 12 (step 102). The electric potential difference applied to the wire portion 11 is increased until at least one of the partial discharge and the voltage breakdown of the insulated magnetic wire 10 occurs (step 103).

Figure 2 further shows that the method 100 further comprises pre-aging or stretching the insulated magnetic wire 10 before cooling or immersing the insulated magnetic wire 10 in the electrically conductive material (see step 101'). In an example, the method further comprises keeping the filler structure 21 at a pre-defined temperature range below 0 °C for a pre-defined duration before applying the electric potential difference. The temperature of the filler structure 21 is measured during the pre-defined duration (step 105).

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a nonlimiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. Any reference signs in the claims should not be construed as limiting the scope of the claims.

### LIST OF REFERENCE SIGNS

| | |
|---|---|
| Arrangement | 1 |
| Insulated magnetic wire | 10 |
| Wire portion | 11 |
| Insulation portion | 12 |
| Container | 20 |
| Filler structure | 21 |
| Filler elements | 22 |
| Display unit | 30 |
| Connection means | 31 |
| Temperature sensor | 32 |
| Power supply unit | 40 |
| First cable | 41 |
| Second cable | 42 |
| Method | 100 |
| Method steps | 101', 101, 102, 103, 104, 105 |

## Claims

1. A method (100) for testing an insulation resistance of an insulated magnetic wire (10), the insulated magnetic wire (10) comprising a wire portion (11) and an insulation portion (12) enclosing the wire portion (11), the method (100) comprising:
- (101) cooling the insulated magnetic wire (10) to a temperature below 0 °C,
- (102) applying an electric potential difference between the wire portion (11) and an electrically conductive material at least partially surrounding the insulation portion (12), and
- (103) increasing the electric potential difference until at least one of a partial discharge and a voltage breakdown of the insulated magnetic wire (10) occurs.

2. The method (100) according to claim 1, wherein the increased electric potential difference before the occurrence of the at least one of the partial discharge and the voltage breakdown is recorded.

3. The method (100) according to any one of the previous claims, wherein the insulated magnetic wire (10) is an insulated hairpin for an electrical motor.

4. The method (100) according to any one of the previous claims, wherein the electric potential difference is increased in pre-defined increments of voltage per time.

5. The method (100) according to any one of the previous claims, wherein the electrically conductive material is a cover that is wrapped around the insulation portion (12).

6. The method (100) according to any one of the previous claims 1 to 4, the method further comprises:
- (104) immersing the insulated magnetic wire (10) at least partially into an electrically conductive material, wherein the insulated magnetic wire (10) is at least partially immersed into a container (20) filled with a filler structure (21) comprising the electrically conductive material.

7. The method (100) according to claim 6, wherein the filler structure (21) comprises a plurality of filler elements (22) comprising the electrically conductive material.

8. The method (100) according to claim 7, wherein the filler elements (22) have a spherical shape.

9. The method (100) according to any one of claims 7 to 8, wherein the filler elements (22) have an extension of 2 mm or less.

10. The method (100) according to any one of claims 6 to 9, wherein the filler elements (22) are granular fillings having a dimeter of 0,1 mm or less.

11. The method (100) according to any one of the previous claims, wherein the electric potential difference is applied by a power supply unit (40) having a first terminal electrically connected to the wire portion (11) of the insulated magnetic wire (10) and having a second terminal electrically connected to the electrically conductive material.

12. The method (100) according to any one of the previous claims, wherein the method further comprises:
- (105) keeping the electrically conductive material at a pre-defined temperature range below 0 °C for a pre-defined duration before applying the electric potential difference, wherein the temperature of the electrically conductive material is measured during the pre-defined duration.

13. The method (100) according to any one of the previous claims, wherein the method further comprises:
- (101') pre-aging or stretching the insulated magnetic wire.

14. The method (100) according to any one of the previous claims, wherein the insulated magnetic wire (10) comprises an at least partially bent form, in particular a substantially U- or V-shaped bent form.

15. The method (100) according to any one of the previous claims, wherein the insulation portion (12) comprises one layer or multiple layers of insulation material, wherein the insulation material comprises Polyether ether keton.

## Patentansprüche

1. Verfahren (100) zum Testen eines Isolationswiderstands eines isolierten Magnetdrahts (10), wobei der isolierte Magnetdraht (10) einen Drahtanteil (11) und einen Isolationsanteil (12) umfasst, der den Drahtanteil (11) umschließt, wobei das Verfahren (100) umfasst:
- (101) Kühlen des isolierten Magnetdrahts (10) auf eine Temperatur unter 0 °C,
- (102) Anlegen einer elektrischen Potentialdifferenz zwischen dem Drahtanteil (11) und einem elektrisch leitfähigen Material, das den Isolationsanteil (12) zumindest teilweise umgibt, und
- (103) Erhöhen der elektrischen Potentialdifferenz, bis mindestens eines von einer Teilentladung und einem Spannungsdurchschlag des isolierten Magnetdrahts (10) auftritt.

2. Verfahren (100) nach Anspruch 1, wobei die erhöhte elektrische Potentialdifferenz vor dem Auftreten von mindestens einem von der Teilentladung und dem Spannungsdurchschlag aufgezeichnet wird.

3. Verfahren (100) nach einem der vorhergehenden Ansprüche, wobei der isolierte Magnetdraht (10) ein isolierter Hairpin für einen Elektromotor ist.

4. Verfahren (100) nach einem der vorhergehenden Ansprüche, wobei die elektrische Potentialdifferenz in vordefinierten Inkrementen von Spannung pro Zeit erhöht wird.

5. Verfahren (100) nach einem der vorhergehenden Ansprüche, wobei das elektrisch leitfähige Material eine Abdeckung ist, die um den Isolationsanteil (12) gewickelt ist.

6. Verfahren (100) nach einem der vorhergehenden Ansprüche 1 bis 4, wobei das Verfahren ferner umfasst:
- (104) Eintauchen des isolierten Magnetdrahts (10) zumindest teilweise in ein elektrisch leitfähiges Material, wobei der isolierte Magnetdraht (10) zumindest teilweise in einen Behälter (20) eingetaucht wird, der mit einer Füllstruktur (21) gefüllt ist, die das elektrisch leitfähige Material umfasst.

7. Verfahren (100) nach Anspruch 6, wobei die Füllstruktur (21) eine Vielzahl von Füllelementen (22) umfasst, die das elektrisch leitfähige Material umfassen.

8. Verfahren (100) nach Anspruch 7, wobei die Füllelemente (22) eine sphärische Form aufweisen.

9. Verfahren (100) nach einem der Ansprüche 7 bis 8, wobei die Füllelemente (22) eine Ausdehnung von 2 mm oder weniger aufweisen.

10. Verfahren (100) nach einem der Ansprüche 6 bis 9, wobei die Füllelemente (22) körnige Füllungen mit einem Durchmesser von 0,1 mm oder weniger sind.

11. Verfahren (100) nach einem der vorhergehenden Ansprüche, wobei die elektrische Potentialdifferenz durch eine Leistungsversorgungseinheit (40) angelegt wird, die einen ersten Anschluss aufweist, der elektrisch mit dem Drahtanteil (11) des isolierten Magnetdrahts (10) verbunden ist, und einen zweiten Anschluss aufweist, der elektrisch mit dem elektrisch leitfähigen Material verbunden ist.

12. Verfahren (100) nach einem der vorhergehenden Ansprüche, wobei das Verfahren ferner umfasst:
- (105) Halten des elektrisch leitfähigen Materials in einem vordefinierten Temperaturbereich unter 0 °C für eine vordefinierte Dauer vor Anlegen der elektrischen Potentialdifferenz, wobei die Temperatur des elektrisch leitfähigen Materials während der vordefinierten Dauer gemessen wird.

13. Verfahren (100) nach einem der vorhergehenden Ansprüche, wobei das Verfahren ferner umfasst:
- (101') Voralterung oder Dehnung des isolierten Magnetdrahts.

14. Verfahren (100) nach einem der vorhergehenden Ansprüche, wobei der isolierte Magnetdraht (10) eine zumindest teilweise gebogene Form, insbesondere eine im Wesentlichen U- oder V-förmige gebogene Form, umfasst.

15. Verfahren (100) nach einem der vorhergehenden Ansprüche, wobei der Isolationsanteil (12) eine Schicht oder mehrere Schichten aus Isolationsmaterial umfasst, wobei das Isolationsmaterial Polyetheretherketon umfasst.

## Revendications

1. Procédé (100) destiné à tester une résistance d'isolation d'un fil magnétique isolé (10), le fil magnétique isolé (10) comprenant une partie fil (11) et une partie isolation (12) enveloppant la partie fil (11), le procédé (100) comprenant :
- (101) le refroidissement du fil magnétique isolé (10) jusqu'à une température inférieure à 0 °C,
- (102) l'application d'une différence de potentiel électrique entre la partie fil (11) et un matériau électriquement conducteur entourant au moins partiellement la partie isolation (12), et
- (103) l'augmentation de la différence de potentiel électrique jusqu'à ce qu'au moins un évènement parmi une décharge partielle et une rupture de tension du fil magnétique isolé (10) survienne.

2. Procédé (100) selon la revendication 1, dans lequel la différence de potentiel électrique croissante avant la survenue de l'au moins un évènement parmi la décharge partielle et la rupture de tension est enregistrée.

3. Procédé (100) selon l'une quelconque des revendications précédentes, dans lequel le fil magnétique isolé (10) est une épingle à cheveux isolée pour un moteur électrique.

4. Procédé (100) selon l'une quelconque des revendications précédentes, dans lequel la différence de potentiel électrique est augmentée par incréments prédéfinis de tension à la fois.

5. Procédé (100) selon l'une quelconque des revendications précédentes, dans lequel le matériau électriquement conducteur est une couverture qui est enroulée autour de la partie isolation (12).

6. Procédé (100) selon l'une quelconque des revendications 1 à 4 précédentes, le procédé comprenant en outre :
- (104) l'immersion au moins partielle du fil magnétique isolé (10) dans un matériau électriquement conducteur, le fil magnétique isolé (10) étant au moins partiellement immergé dans un récipient (20) garni d'une structure de garnissage (21) comprenant le matériau électriquement conducteur.

7. Procédé (100) selon la revendication 6, dans lequel la structure de garnissage (21) comprend une pluralité d'éléments de garnissage (22) comprenant le matériau électriquement conducteur.

8. Procédé (100) selon la revendication 7, dans lequel les éléments de garnissage (22) ont une forme sphérique.

9. Procédé (100) selon l'une quelconque des revendications 7 à 8, dans lequel les éléments de garnissage (22) ont une étendue de 2 mm ou moins.

10. Procédé (100) selon l'une quelconque des revendications 6 à 9, dans lequel les éléments de garnissage (22) sont des garnitures granulaires ayant un diamètre de 0,1 mm ou moins.

11. Procédé (100) selon l'une quelconque des revendications précédentes, dans lequel la différence de potentiel électrique est appliquée par une unité d'alimentation électrique (40) ayant une première borne reliée électriquement à la partie fil (11) du fil magnétique isolé (10) et ayant une deuxième borne reliée électriquement au matériau électriquement conducteur.

12. Procédé (100) selon l'une quelconque des revendications précédentes, le procédé comprenant en outre :
- (105) le maintien du matériau électriquement conducteur dans une plage de température prédéfinie inférieure à 0 °C pendant une durée prédéfinie avant l'application de la différence de potentiel électrique, la température du matériau électriquement conducteur étant mesurée pendant la durée prédéfinie.

13. Procédé (100) selon l'une quelconque des revendications précédentes, le procédé comprenant en outre :
- (101') le prévieillissement ou l'étirage du fil magnétique isolé.

14. Procédé (100) selon l'une quelconque des revendications précédentes, dans lequel le fil magnétique isolé (10) comprend une forme au moins partiellement courbée, en particulier une forme courbée sensiblement en forme de U ou de V.

15. Procédé (100) selon l'une quelconque des revendications précédentes, dans lequel la partie isolation (12) comprend une couche ou de multiples couches de matériau d'isolation, le matériau d'isolation comprenant de la polyétheréthercétone.
